(19) Europäisches Patentamt
European Patent Office
Office européen des brevets

(11) EP 4 796 615 A1

(12) **EUROPEAN PATENT APPLICATION**
published in accordance with Art. 153(4) EPC

(43) Date of publication:
**26.08.2026 Bulletin 2026/35**

(21) Application number: **24882921.0**

(22) Date of filing: **25.10.2024**

(51) International Patent Classification (IPC):
***C09K 13/00*** (2006.01) ***C09D 5/00*** (2006.01)
***C23C 16/04*** (2006.01) ***C23C 16/44*** (2006.01)
***H01L 21/32*** (2006.01) ***H01L 21/285*** (2006.01)

(52) Cooperative Patent Classification (CPC):
**C09D 5/00; C09K 13/00; C23C 16/04; C23C 16/44; H10P 14/42; H10P 14/61**

(86) International application number:
**PCT/KR2024/016482**

(87) International publication number:
**WO 2025/089895 (01.05.2025 Gazette 2025/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.10.2023 KR 20230144207**

(71) Applicants:
- **SK Specialty Co., Ltd.**
  **Yeongju-si, Gyeongsangbuk-do 03188 (KR)**
- **Industry-University Cooperation Foundation Hanyang University ERICA Campus**
  **Ansan-si, Gyeonggi-do 15588 (KR)**

(72) Inventors:
- **LEE, Ji Hun**
  **Sejong 30068 (KR)**
- **KWAK, Junghun**
  **Sejong 30068 (KR)**
- **LEE, Jinhee**
  **Sejong 30068 (KR)**
- **CHUNG, Sung-Woong**
  **Seongnam-si Gyeonggi-do 13469 (KR)**
- **KIM, Woo-Hee**
  **Ansan-si Gyeonggi-do 15588 (KR)**
- **LEE, Jeong-Min**
  **Ansan-si Gyeonggi-do 15588 (KR)**
- **LEE, Seo-Hyun**
  **Ansan-si Gyeonggi-do 15588 (KR)**

(74) Representative: **Isarpatent**
**Patent- und Rechtsanwälte Part G mbB**
**Friedrichstrasse 31**
**80801 München (DE)**

(54) **COMPOSITION FOR SEMICONDUCTOR PROCESS AND METHOD FOR MANUFACTURING SEMICONDUCTOR DEVICE**

(57) A semiconductor process composition is provided comprising a fluorine-containing compound, wherein the semiconductor process composition has a first increase of the water contact angle of more than 20° and includes a fluorine-containing ketone-based compound, and can perform a deposition inhibition function by adsorbing to a metal nitride film or a metal film.

FIG. 3

inert gas
NGA
GA
210
100
130
120
110



Processed by Luminess, 75001 PARIS (FR)

## Description

CROSS-REFERENCE TO RELATED APPLICATIONS

The present application claims priority under 35 U.S.C. 119(a) to Korean Patent Application No. No. 10-2023-0144207, filed on October 25, 2023, which is incorporated herein by reference in its entirety.

BACKGROUND

Technology field

The embodiments of the present disclosure relate to a composition for semiconductor processes and a method for manufacturing a semiconductor device.

Description of Related Art

As the integration density and aspect ratio of various electronic devices, including semiconductor devices, increase, various limitations and problems may arise in the conventional top-down lithography and etching processes performed from the top to the bottom of the structure. For example, with the high integration of memory devices, the aspect ratio and stacking layer count of 3D vertical NAND (i.e., VNAND) devices are increasing, while the tier size is decreasing in the vertical direction.

Consequently, when forming cells containing information storage films, particularly charge trap layers, using conventional top-down lithography/etching processes, non-uniformity between cells and resulting interference concerns may occur.

Therefore, there is a need for technological development and related research to overcome the limitations of conventional top-down cell fabrication and to expand the degrees of freedom of atomic-scale patterning methods within 3D structures. Research is being conducted on the technological development of ultra-precision patterning methods applicable to the interior of 3D NAND cells to overcome scaling limitations for the development of next-generation NAND flash devices and to further increase the number of stacked layers.

In particular, in semiconductor manufacturing processes, thin film deposition refers to the process of forming conductive, insulating, or semiconductor materials on a wafer. Thin film deposition methods may include Atomic Layer Deposition (ALD) and Chemical Vapor Deposition (CVD). Atomic Layer Deposition is a process that deposits atoms one layer at a time and can be used where miniaturization is required.

SUMMARY

Technical challenges:

Various embodiments of the present disclosure aim to provide a composition for a semiconductor process and a method for manufacturing a semiconductor device that achieves an enhanced selectivity ratio in a process of selectively depositing a target film by region.

Technical Solution:

The semiconductor process composition according to an embodiment of the present disclosure comprises a compound containing fluorine, and a first increase of the water contact angle measured using the following measurement method 1 exceeds 20°.

Measurement Method 1

1) The surface of a semiconductor substrate containing a titanium nitride film is surface-treated with hydrogen fluoride.
2) The semiconductor process composition is deposited on the surface-treated titanium nitride film for 30 seconds at a temperature of 150°C and a process pressure of 1 Torr.
3) At room temperature, the first water contact angle of the titanium nitride film surface-treated with hydrogen fluoride is measured.
4) At room temperature, the second water contact angle of the surface on which the semiconductor process

composition is deposited is measured.
5) The first increase of the water contact angle is the value obtained by subtracting the first water contact angle from the second water contact angle.

In an embodiment, a second increase of the water contact angle measured using the following measurement method 2 may exceed 20°.

Measurement Method 2

1) The surface of a semiconductor substrate including a tungsten layer is surface-treated with hydrogen fluoride.
2) The semiconductor process composition is deposited on the surface-treated tungsten layer for 30 seconds at a temperature of 150°C and a process pressure of 1 Torr.
3) At room temperature, the third water contact angle of the tungsten layer surface-treated with hydrogen fluoride is measured.
4) At room temperature, the fourth water contact angle of the surface on which the semiconductor process composition is deposited is measured.
5) The second increase of the water contact angle is the value obtained by subtracting the third water contact angle from the fourth water contact angle.

In an embodiment, the fluorine-containing compound may include a ketone-based compound.
In an embodiment, the fluorine-containing compound may be represented by the following Chemical Formula 1.

Chemical Formula 1

O
R1 R2

In the Chemical Formula 1, R1 is an alkyl group substituted with fluorine and comprising 1 to 3 carbon atoms, and R2 is an alkenyl group substituted with fluorine and comprising 1 to 6 carbon atoms.
In an embodiment, the compound containing fluorine may be represented by the following Chemical Formula 2.

Chemical Formula 2

O R5
R1 R3
R4

In the Chemical Formula 2, R1 is an alkyl group substituted with fluorine and comprising 1 to 3 carbon atoms, R3 is an alkyl group substituted with fluorine and comprising 1 to 3 carbon atoms, R4 is selected from at least one group consisting of hydrogen, fluorine, or an alkyl group substituted with fluorine and comprising 1 to 3 carbon atoms, and R5 comprises a hydroxyl group.
In an embodiment, the compound containing fluorine may include hexafluoroacetylacetone.
In an embodiment, the compound containing fluorine may have a molecular weight of about 100 g/mol to about 500 g/mol.
In an embodiment, the boiling point of the semiconductor process composition at atmospheric pressure may be 60°C to 100°C.

In an embodiment, the eighth water contact angle measured using the following measurement method 3 may be 20° to 50°.

Measurement Method 3

1) The surface of a semiconductor substrate including a silicon oxide film is surface-treated with hydrogen fluoride.
2) The semiconductor process composition is deposited on the surface-treated silicon oxide film for 30 seconds at a temperature of 150°C and a process pressure of 1 Torr.
3) The eighth water contact angle is measured at room temperature on the surface of the silicon oxide film on which the semiconductor process composition is deposited.

A method for manufacturing a semiconductor device according to an embodiment of the present disclosure comprises: preparing a semiconductor substrate including a deposition target area and a deposition exclusion area; a first adsorption operation of introducing an inhibitor containing fluorine, which is selectively adsorbed to the deposition exclusion area, onto the semiconductor substrate; a first purge operation of removing the inhibitor remaining in the deposition target area; and a second adsorption operation of introducing the inhibitor to the deposition exclusion area after the first purge operation and an operation of forming a thin film in the deposition target area.

The method for manufacturing a semiconductor device according to an embodiment of the present disclosure may further include: a second purge operation for removing an inhibitor remaining in the deposition target area after the second adsorption operation; a third adsorption operation for introducing the inhibitor into the deposition exclusion area after the second purge operation; and a third purge operation for removing an inhibitor remaining in the deposition target area after the third adsorption operation.

In an embodiment, the deposition target area may include a silicon oxide film or a silicon nitride film, and the deposition exclusion area may include a titanium nitride film or a tungsten layer.

In an embodiment, in the first purge operation, an inert gas is introduced into the semiconductor substrate, and the process time in the first purge operation may be 1.5 to 4.0 times longer than the process time in the first adsorption operation.

In an embodiment, in the first adsorption operation and the second adsorption operation, the adsorption process temperature may be 50°C to 120°C higher than the boiling point of the inhibitor.

In an embodiment, in the first purging operation, the purging process temperature may be 70°C to 200°C higher than the boiling point of the inhibitor.

The deposition inhibitor composition according to an embodiment is a semiconductor process composition that adsorbs to a titanium nitride film or a tungsten layer to inhibit the deposition of additional process materials, and comprises a fluorine-based compound represented by the following Chemical Formula 1.

Chemical Formula 1

O
R1
R2

In the Chemical Formula 1, R1 is an alkyl group substituted with fluorine and comprising 1 to 3 carbon atoms, and R2 is an alkenyl group substituted with fluorine and comprising 1 to 6 carbon atoms.

The deposition inhibitor composition according to an embodiment may include a fluorine-based compound represented by the following Chemical Formula 2.

Chemical Formula 2

In the Chemical Formula 2, R1 is an alkyl group substituted with fluorine and comprising 1 to 3 carbon atoms, R3 is an alkyl group substituted with fluorine and comprising 1 to 3 carbon atoms, R4 is selected from at least one group consisting of hydrogen, fluorine, or an alkyl group substituted with fluorine and comprising 1 to 3 carbon atoms, and R5 comprises a hydroxyl group.

The deposition inhibitor composition according to an embodiment may comprise a fluorine-based compound represented by the following Chemical Formula 3.

Chemical Formula 3

In an embodiment, the fluorine-based compound may have a molecular weight of about 100 g/mol to about 500 g/mol.

In an embodiment, the fluorine-based compound may have a boiling point of 60°C to 100°C at atmospheric pressure.

Advantageous Effects

The semiconductor process composition according to an embodiment of the present disclosure includes a compound containing fluorine, effectively adsorbs onto a titanium nitride film, and can have a first increase of the water contact angle exceeding about 20°.

Accordingly, the semiconductor process composition according to an embodiment of the present disclosure is temporarily adsorbed onto the titanium nitride film, and thereby effectively prevents the deposition of a thin film on the titanium nitride film.

In particular, since the semiconductor process composition according to the embodiment contains fluorine, the semiconductor process composition can effectively prevent a chemical reaction between the precursor for forming the thin film and the titanium nitride film.

In addition, the semiconductor process composition according to the embodiment is effectively adsorbed onto a tungsten layer and can have a second increase of the water contact angle exceeding about 20°.

Accordingly, the semiconductor process composition according to the embodiment is temporarily adsorbed onto the tungsten layer, thereby effectively preventing the deposition of the thin film on the tungsten layer.

In addition, the semiconductor process composition according to the embodiment may include a ketone-based compound containing fluorine. In addition, the semiconductor process composition according to the embodiment may include functional groups such as hydroxyl groups.

Accordingly, the ketone group and/or the hydroxyl group are effectively adsorbed to the deposition exclusion region, and the fluorine can be exposed to the surface of the deposition prevention layer formed by the semiconductor process composition according to the embodiment.

Accordingly, the semiconductor process composition according to the embodiment can effectively protect the deposition exclusion region from the precursor. Accordingly, a thin film can be formed in the deposition target region with a

high selectivity ratio.

In addition, the compound containing fluorine may have a molecular weight of 100 g/mol to 500 g/mol, and the boiling point of the semiconductor process composition may be 60°C to 100°C at atmospheric pressure.

Accordingly, the semiconductor process composition according to the embodiment can be easily introduced into a semiconductor substrate even at low temperatures. Accordingly, the semiconductor process composition according to the embodiment can form the deposition prevention layer thinly and uniformly in the deposition exclusion region.

Furthermore, the semiconductor process composition according to the embodiment is not adsorbed onto the silicon oxide film or is weakly adsorbed. Accordingly, the semiconductor process composition according to the embodiment does not form the deposition prevention layer on the silicon oxide film. Accordingly, the semiconductor process composition according to the embodiment can selectively deposit a target film only on the silicon oxide film.

In addition, the method for manufacturing a semiconductor device according to the embodiment includes a first purge operation between the first adsorption operation and the second adsorption operation. That is, the method for manufacturing a semiconductor device according to the embodiment introduces the inhibitor stepwise into the deposition exclusion area to form the reaction inhibition layer stepwise.

Accordingly, the method for manufacturing a semiconductor device according to the embodiment can form the reaction inhibition layer thinly and uniformly in the deposition exclusion area while effectively removing residues of the inhibitor from the deposition target area.

In addition, the method for manufacturing a semiconductor device according to the embodiment can utilize the process time of the first purge operation sufficiently long by using the inhibitor. At this time, since the inhibitor is strongly bound to the deposition exclusion area, the first purge operation can have a sufficiently long process time.

Accordingly, the method for manufacturing a semiconductor device according to the embodiment can form the thin film in the deposition target area with an improved selectivity.

In addition, the method for manufacturing a semiconductor device according to the embodiment can perform a first adsorption operation and a second adsorption operation at an appropriate process temperature, and perform the first purge operation at an appropriate process temperature.

Accordingly, the method for manufacturing a semiconductor device according to the embodiment can form the reaction inhibition layer thinly and uniformly in the deposition exclusion area, while effectively removing the residue of the inhibitor in the deposition target area.

## BRIEF DESCRIPTION OF THE DRAWINGS

FIGS. 1 to 9 are drawings illustrating a region-selective atomic layer deposition process according to an embodiment of the present disclosure.

FIG. 10 is a drawing illustrating a cross-section of a semiconductor substrate including a titanium nitride film formed according to an embodiment of the present disclosure.

FIG. 11 is a drawing illustrating a cross-section of a semiconductor substrate including a titanium nitride film formed according to a comparative example.

FIG. 12 is a drawing illustrating a cross-section of a semiconductor substrate including a tungsten layer formed according to an embodimentof the present disclosure.

FIG. 13 is a drawing illustrating a cross-section of a semiconductor substrate including a tungsten layer formed according to a comparative example.

## DETAILED DESCRIPTION

In the description of the embodiments, where each region, plane, layer, or substrate, etc. is described as being formed "on" or "under" another region, plane, layer, or substrate, etc., "on" and "under" include both being formed "directly" and "indirectly" through other components. Furthermore, the reference for the "on" or "under" of each component is described based on the drawings. The size of each component in the drawings may be exaggerated for illustrative purposes and does not imply the actual size applied.

A method for manufacturing a semiconductor device according to an embodiment includes the operation of forming a thin film on a semiconductor substrate. A method for manufacturing a semiconductor device according to an embodiment may selectively deposit the thin film on the semiconductor substrate using an inhibitor.

A method for manufacturing a semiconductor device according to an embodiment includes the operation of preparing a semiconductor substrate comprising a deposition target area and a deposition exclusion area; a first adsorption operation of introducing an inhibitor containing fluorine, which is selectively adsorbed to the deposition exclusion area, onto the semiconductor substrate; a first purge operation of removing the inhibitor remaining in the

deposition target area; a second adsorption operation for introducing the inhibitor into the deposition exclusion area after the first purge operation; and an operation of forming a thin film in the deposition target area.

Additionally, the method for manufacturing a semiconductor device according to the embodiment may further include: a second purge operation for removing the inhibitor remaining in the deposition target area after the second adsorption operation; a third adsorption operation for introducing the inhibitor into the deposition exclusion area after the second purge operation; and a third purge operation for removing the inhibitor remaining in the deposition target area after the third adsorption operation.

The method for manufacturing a semiconductor device according to the embodiment may selectively form the thin film on the semiconductor substrate by the following process.

The method for forming the thin film on the semiconductor substrate may include the operations of preparing the semiconductor substrate, a first adsorption operation, a first purge operation, a second adsorption operation, a second purge operation, a third adsorption operation, a third purge operation, a deposition operation, and a cleaning operation.

First, the semiconductor substrate is provided.

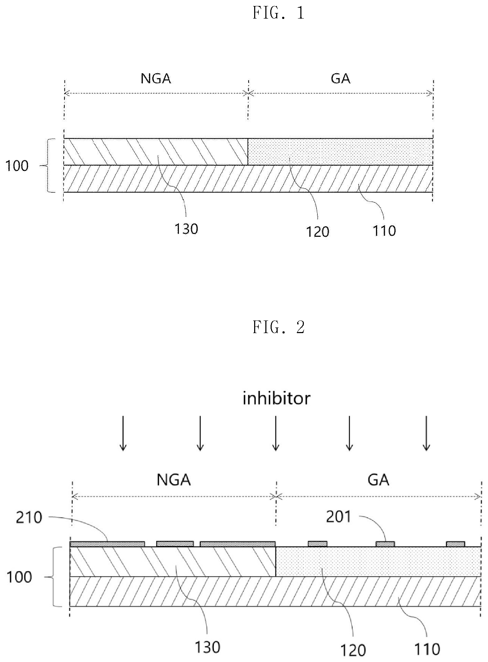

As illustrated in FIG. 1, the semiconductor substrate (100) comprises a support layer (110), a first material layer (120), and a second material layer (130).

The support layer (110) may be a silicon wafer. The support layer (110) may form a first layer of the semiconductor substrate (100) extending both in a deposition target area (GA) and a deposition exclusion area (NGA). The second material layer (130) may be disposed on the support layer (110) only in the deposition exclusion area (NGA).

The first material layer (120) is disposed on the support layer (110). The first material layer (120) is disposed on the support layer (110) only in the deposition target area (GA). The first material layer (120) may be formed by deposition on the support layer (110). The first material layer (120) may be disposed next to the second material layer (130). Additionally, the first material layer (120) may be disposed adjacent to the second material layer (130). The first material layer (120) may be in direct contact with the second material layer (130). The first material layer (120) may be placed on the same plane as the second material layer (130).

The second material layer (130) is placed on the support layer (110). The second material layer (130) may be formed by deposition on the support layer (110). The second material layer (130) may be placed next to the first material layer (120). Additionally, the second material layer (130) may be placed adjacent to the first material layer (120). The second material layer (130) may be in direct contact with the first material layer (120). The second material layer (130) may be placed on the same plane as the first material layer (120).

Additionally, the semiconductor substrate (100) includes a deposition target area (GA) and a deposition exclusion area (NGA). The deposition target area (GA) may be an area where a thin film is formed on the semiconductor substrate (100). The deposition target area (GA) may correspond to an area where the first material layer (120) is placed on the support layer (110). The deposition target area (GA) may correspond to an upper surface area of the first material layer (120). The deposition target area (GA) may include the first material layer (120).

The deposition exclusion area (NGA) may be an area where the thin film 201 is not formed on the semiconductor substrate (100). The deposition exclusion area (NGA) may be placed adjacent to the deposition target area (GA). The deposition exclusion area (NGA) may correspond to an area where the second material layer (130) is placed. The deposition exclusion area (NGA) may correspond to an upper surface area of the second material layer (130). The deposition exclusion area (NGA) may include the second material layer (130). The support layer (110) may be disposed across the deposition target area (GA) and the deposition exclusion area (NGA).

The first material layer (120) may include a silicon oxide film or a silicon nitride film. The second material layer (130) may include a titanium nitride film or a tungsten layer.

Subsequently, the semiconductor substrate (100) may be surface-treated with a diluted hydrogen fluoride (HF) solution. The semiconductor substrate (100) may be surface-treated with the hydrogen fluoride solution for about 10 seconds to about 120 seconds. Additionally, the diluted hydrogen fluoride solution may be formed by dissolving hydrogen fluoride in deionized water at a concentration of about 0.1 wt% to about 5 wt%.

Accordingly, the upper surface of the first material layer (120) and the upper surface of the second material layer (130) can be surface-treated with the diluted hydrogen fluoride solution. In particular, hydroxyl groups can be activated on the surface of the silicon oxide film by surface treatment with the hydrogen fluoride solution. Additionally, amine groups can be activated on the surface of the silicon nitride film by surface treatment with the hydrogen fluoride solution.

Subsequently, an inhibitor is introduced onto the semiconductor substrate (100). The inhibitor can suppress surface reactions during the deposition process. The inhibitor may be a reaction inhibitor that suppresses reactions.

In addition, the inhibitor may be selectively adsorbed onto the semiconductor substrate (100). Accordingly, the inhibitor may selectively suppress the deposition of the thin film on the surface of the semiconductor substrate (100).

In particular, the inhibitor may be used in an atomic layer deposition process. The inhibitor may be a composition used in a process for manufacturing semiconductor devices. The inhibitor may be a composition for semiconductor processes.

The inhibitor may include a fluorine-based compound. The inhibitor may be a composition containing the fluorine-

based compound. The inhibitor may include the fluorine-based compound in an amount exceeding about 90 wt% based on the total weight. The inhibitor may include the fluorine-based compound in an amount exceeding about 95 wt% based on the total weight. The inhibitor may include the fluorine-based compound in an amount exceeding about 99 wt% based on the total weight. The inhibitor may include the fluorine-based compound alone.

The compound containing fluorine may include a ketone-based compound. The fluorine-based compound may be a ketone-based compound.

The fluorine-based compound may be represented by the following Chemical Formula 1.

[Chemical Formula 1]

O
R1 R2

In the Chemical Formula 1, R1 is an alkyl group substituted with fluorine and containing 1 to 3 carbon atoms, and R2 is an alkenyl group substituted with fluorine and containing 1 to 6 carbon atoms.

R1 may be an alkyl group substituted with fluorine and containing 1 to 2 carbon atoms. R1 may contain 1 to 5 fluorine elements.

Additionally, R2 may be an alkenyl group containing 2 to 5 carbon atoms. R2 may contain 1 to 5 fluorine elements.

The fluorine-based compound may be represented by the following Chemical Formula 2.

[Chemical Formula 2]

O R5
R1 R3
R4

In the Chemical Formula 2, R1 is an alkyl group substituted with fluorine and comprising 1 to 3 carbon atoms, R3 is an alkyl group substituted with fluorine and comprising 1 to 3 carbon atoms, R4 is selected from at least one group consisting of hydrogen, fluorine, or an alkyl group substituted with fluorine and comprising 1 to 3 carbon atoms, and R5 comprises a hydroxyl group.

The fluorine compound may include hexafluoroacetylacetone.

The fluorine compound may be represented by the following Chemical Formula 3.

[Chemical Formula 3]

H
O O
$F_3C$ $CF_3$

The fluorine-based compound may have a molecular weight of about 100 g/mol to about 500 g/mol. The fluorine-based compound may have a molecular weight of about 100 g/mol to about 400 g/mol.

The fluorine-based compound may have a boiling point of about 60°C to about 100°C at atmospheric pressure. The fluorine-based compound may have a boiling point of about 60°C to about 90°C at atmospheric pressure.

Subsequently, for the inhibitor to be introduced into the semiconductor substrate (100), the semiconductor substrate (100) may be placed in a vacuum deposition chamber. After the semiconductor substrate (100) is placed in the chamber, an inert gas is introduced into the chamber, and the interior of the chamber may be purged.

The inhibitor may be introduced into the chamber. As shown in FIG. 2, the inhibitor is introduced into the semiconductor substrate (100). Accordingly, the first adsorption operation may proceed.

Accordingly, the inhibitor is selectively adsorbed onto the deposition exclusion region (NGA). Accordingly, a first reaction inhibition layer (210) is formed on the deposition exclusion region (NGA). The first reaction inhibition layer (210) is formed on the upper surface of the second material layer (130). The inhibitor can be adsorbed onto the upper surface of the second material layer (130) to form the first reaction inhibition layer (210).

Additionally, a portion (201) of the inhibitor may remain in the deposition target region (GA).

That is, the inhibitor may be adsorbed more onto the titanium nitride film and the tungsten layer than onto the silicon oxide film and the silicon nitride film. The area ratio in which the inhibitor is adsorbed may be greater on the titanium nitride film and the tungsten layer than on the silicon oxide film and the silicon nitride film.

In the first adsorption operation, the first adsorption process temperature may be about 50°C to about 120°C higher than the boiling point of the inhibitor. The first adsorption process temperature may be about 100°C to about 300°C.

Additionally, in the first adsorption operation, the first adsorption process time may be about 5 seconds to about 30 seconds. In the first adsorption operation, the first adsorption process time may be about 5 seconds to about 20 seconds.

Additionally, in the first adsorption operation, the first adsorption process pressure may be about 0.2 Torr to about 5 Torr. The first adsorption process pressure may be about 0.3 Torr to about 3 Torr.

After the first adsorption operation is completed, the first purge operation may be performed.

In the first purge operation, an inert gas such as nitrogen, argon, or helium is introduced into the chamber. In the first purge step, an inert gas such as nitrogen, argon, or helium is introduced into the chamber of the semiconductor substrate (100).

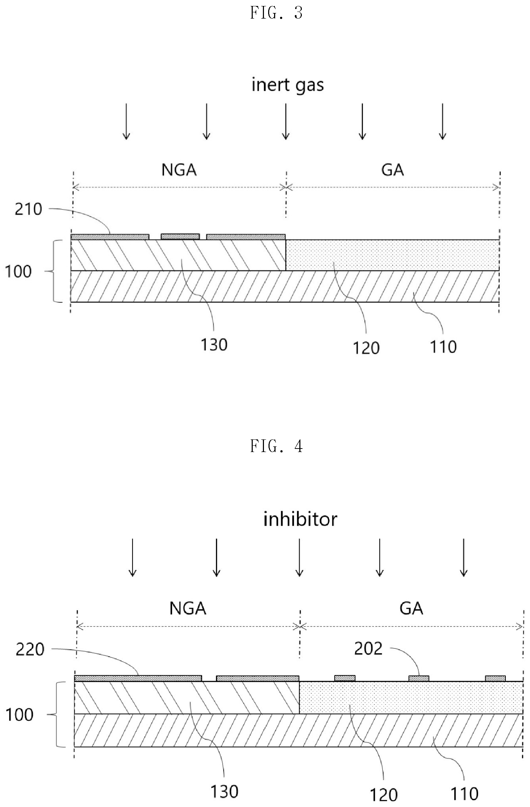

Accordingly, as illustrated in FIG. 3, the inhibitor (201) remaining on the first material layer (120) is removed. That is, the residue (201) of the inhibitor is removed from the deposition target area (GA). Additionally, the upper surface of the first material layer (120) may be exposed entirely.

In the first purging operation, the first purging process temperature may be about 50°C to about 120°C higher than the boiling point of the inhibitor. The first purging process temperature may be about 100°C to about 300°C.

In addition, in the first purging operation, the first purging process time may be about 5 seconds to about 60 seconds. In the first purging operation, the first purging process time may be about 2 seconds to about 60 seconds.

Afterward, the second adsorption operation may proceed. After the first purge operation is completed, the inhibitor may be reintroduced into the chamber.

As illustrated in FIG. 4, the inhibitor is introduced into the semiconductor substrate (100). Accordingly, the second adsorption operation may proceed.

Accordingly, the inhibitor is additionally adsorbed onto the deposition exclusion region (NGA). Accordingly, a second reaction inhibition layer (220) is formed on the deposition exclusion region (NGA). The second reaction inhibition layer (220) is formed on the upper surface of the second material layer (130). The inhibitor may be adsorbed onto the upper surface of the second material layer (130) to form the second reaction inhibition layer (220).

Additionally, a portion (202) of the inhibitor may remain in the deposition target region (GA).

In the second adsorption operation, the second adsorption process temperature may be about 50°C to about 120°C higher than the boiling point of the inhibitor. The second adsorption process temperature may be about 100°C to about 300°C.

Additionally, in the second adsorption operation, the second adsorption process time may be about 5 seconds to about 30 seconds. In the second adsorption operation, the second adsorption process time may be about 5 seconds to about 20 seconds.

Additionally, in the second adsorption operation, the second adsorption process pressure may be about 0.2 Torr to about 5 Torr. The second adsorption process pressure may be about 0.3 Torr to about 3 Torr.

After the second adsorption operation is completed, the second purge operation may proceed.

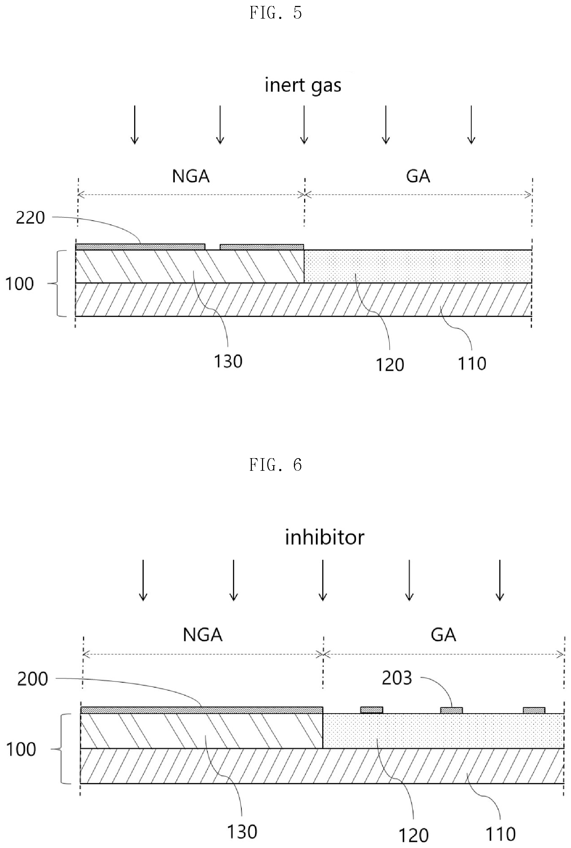

As illustrated in FIG. 5, in the second purge operation, an inert gas such as nitrogen, argon, or helium is introduced into the chamber.

Accordingly, the inhibitor (202) remaining on the first material layer (120) is removed. That is, the residue (202) of the inhibitor is removed from the deposition target area (GA) and the upper surface of the first material layer (120) is exposed entirely.

In the second purging operation, the second purging process temperature may be about 50°C to about 120°C higher than the boiling point of the inhibitor. The second purging process temperature may be about 100°C to about 300°C.

In addition, in the second purging operation, the second purging process time may be about 5 seconds to about 60 seconds. In the second purging operation, the second purging process time may be about 20 seconds to about 60

seconds.

Subsequently, the third adsorption operation may be introduced. After the second purging operation is completed, the inhibitor may be reintroduced into the chamber.

As illustrated in FIG. 6, the inhibitor is introduced into the semiconductor substrate (100). Accordingly, the third adsorption operation can proceed.

Accordingly, the inhibitor is additionally adsorbed onto the deposition exclusion region (NGA). Accordingly, a third reaction inhibition layer (200) is formed on the deposition exclusion region (NGA). The third reaction inhibition layer (200) is formed on the upper surface of the second material layer (130). The inhibitor can be adsorbed onto the upper surface of the second material layer (130) to form the third reaction inhibition layer (200). The third reaction inhibition layer (200) can cover the entire upper surface of the second material layer (130).

Additionally, a portion (203) of the inhibitor may remain in the deposition target region (GA).

In the third adsorption operation, the third adsorption process temperature may be about 50°C to about 120°C higher than the boiling point of the inhibitor. The third adsorption process temperature may be about 100°C to about 300°C.

Additionally, in the third adsorption operation, the third adsorption process time may be about 5 seconds to about 30 seconds. In the third adsorption operation, the third adsorption process time may be about 5 seconds to about 20 seconds.

Additionally, in the third adsorption operation, the third adsorption process pressure may be about 0.2 Torr to about 5 Torr. The third adsorption process pressure may be about 0.3 Torr to about 3 Torr.

After the third adsorption operation is completed, the third purging operation may proceed.

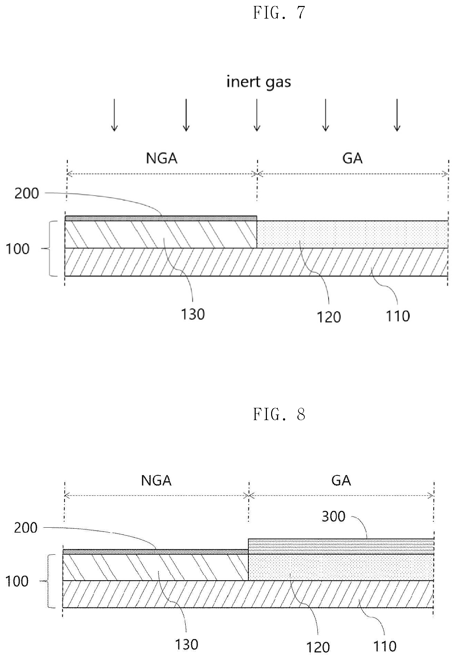

As illustrated in FIG. 7, in the third purging operation, an inert gas such as nitrogen, argon, or helium is introduced into the chamber.

Accordingly, the inhibitor (203) remaining on the first material layer (120) is removed. That is, the residue (203) of the inhibitor is removed from the deposition target area (GA) and the upper surface of the first material layer (120) may be exposed entirely.

In the third purging operation, the third purging process temperature may be about 50°C to about 120°C higher than the boiling point of the inhibitor. The third purging process temperature may be about 100°C to about 300°C.

In addition, in the third purging operation, the third purging process time may be about 5 seconds to about 60 seconds. In the third purging operation, the third purging process time may be about 20 seconds to about 60 seconds.

Accordingly, a reaction inhibitor layer (200) can be formed uniformly over the deposition exclusion area (NGA).

Subsequently, the deposition process described above is carried out. As illustrated in FIG. 8, a thin film (300) is formed in the deposition target area (GA). The thin film (300) may be an oxide film, a nitride film, or a metal film. Additionally, the thin film (300) may be formed by an atomic layer formation process.

To form the thin film (300), a precursor is introduced into the chamber. To form the thin film (300), the precursor is introduced into the semiconductor substrate (100). The precursor may include a first precursor and a second precursor.

The first precursor may include diisopropylaminosilane or diethylaminotrimethylsilane.

In addition, the second precursor may include an oxygen source containing oxygen. The precursor may further include ozone gas. That is, the silane and the ozone may react with each other to form the thin film (300).

The first precursor and the second precursor react in the deposition target area (GA) to form the thin film, but do not react in the reaction inhibition layer (200). That is, the first precursor and the second precursor react on the upper surface of the first material layer (120) but do not react on the upper surface of the reaction inhibition layer (200).

That is, the first precursor and the second precursor are alternately introduced into the deposition target area (GA) to form the thin film (300).

Accordingly, the thin film (300) can be formed only in the deposition target area (GA).

In addition, the precursor may include a metal such as ruthenium. Accordingly, a metal thin film can be formed in the deposition target area (GA).

The atomic layer deposition process may be performed for approximately 30 to approximately 500 times.

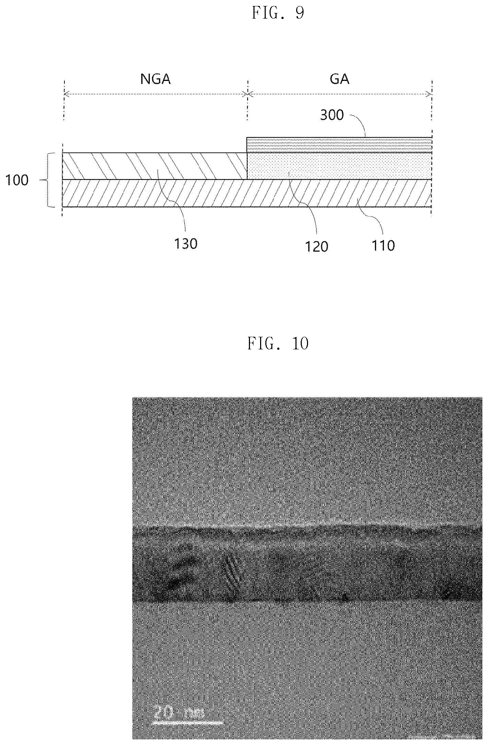

Afterward, a cleaning process is performed. As illustrated in FIG. 9, a strip gas is injected into the chamber, and the reaction inhibitor layer (200) can be removed. The strip gas may be hydrogen fluoride gas.

In the cleaning process, the strip gas may be supplied into the chamber for about 10 seconds to about 60 seconds.

Additionally, the cleaning process may further include a process of purging the interior of the chamber.

Additionally, the cleaning process may include a process of immersing the semiconductor substrate (100) in a strip solution. The strip solution may include a hydrogen fluoride solution.

The inhibitor may alter the surface characteristics of the deposition exclusion surface. The inhibitor may alter the surface characteristics of the deposition exclusion region (NGA) without significantly altering the surface characteristics of the deposition target region (GA).

The inhibitor may cause a first increase of the water contact angle. The first increase of the water contact angle may be measured using the following measurement method 1.

Measurement Method 1

1) The surface of a first semiconductor substrate containing a titanium nitride film is surface-treated with a hydrogen fluoride solution. The hydrogen fluoride solution may contain 99.9 wt% deionized water and 0.1 wt% hydrogen fluoride. The first semiconductor substrate may be immersed for approximately 30 seconds.
2) The inhibitor is deposited on the surface-treated titanium nitride film for 30 seconds at a temperature of approximately 150°C and a process pressure of 1 Torr.
3) At room temperature, the first water contact angle of the titanium nitride film surface-treated with hydrogen fluoride is measured. The first water contact angle is measured before the inhibitor is deposited on the surface-treated titanium nitride film.
4) At room temperature, the second water contact angle of the surface on which the inhibitor is deposited is measured.
5) The first increase of the water contact angle is the value obtained by subtracting the first water contact angle from the second water contact angle.

The first increase of the water contact angle can be derived by the following Equation 1.

First increase of the water contact angle = Second water contact angle - First water contact angle [Equation 1]

The first increase of the water contact angle may exceed approximately 20°. The first increase of the water contact angle may exceed approximately 25°. The first increase of the water contact angle may exceed approximately 30°. The first increase of the water contact angle may exceed approximately 35°. The first increase of the water contact angle may exceed approximately 40°. The maximum value of the first increase of the water contact angle may be approximately 80°.
The first water contact angle may be approximately 20° to approximately 50°. The first water contact angle may be approximately 25° to approximately 45°. The first water contact angle may be approximately 25° to approximately 40°.
The second water contact angle may be approximately 50° to approximately 85°. The second water contact angle may be approximately 55° to approximately 80°. The second water contact angle may be approximately 60° to approximately 75°.
The first semiconductor substrate may be formed by a plasma-enhanced chemical vapor deposition process.
To form the first semiconductor substrate, a titanium-based precursor and a nitrogen-based precursor are introduced onto a silicon wafer, and the titanium nitride film may be formed.
The process temperature for forming the titanium nitride film may be approximately 400°C to approximately 500°C. Additionally, the titanium-based precursor may be tetrachlorotitanium ($TiCl_4$), and the nitrogen-based precursor may be ammonia ($NH_3$) or nitrogen ($N_2$).
The titanium nitride film may contain TiN as a main component.
The inhibitor may cause a second increase of the water contact angle. The second increase of the water contact angle described above can be measured using the following measurement method 2.

Measurement Method 2

1) The surface of a second semiconductor substrate containing a tungsten layer is surface-treated with a hydrogen fluoride solution. The hydrogen fluoride solution may contain 99.9 wt% deionized water and 0.1 wt% hydrogen fluoride. The second semiconductor substrate may be immersed for approximately 30 seconds.
2) The inhibitor is deposited on the surface-treated tungsten layer for 30 seconds at a temperature of approximately 150°C and a process pressure of 1 Torr.
3) At room temperature, the third water contact angle of the tungsten layer surface-treated with hydrogen fluoride is measured. The third water contact angle is measured before the inhibitor is deposited on the surface-treated tungsten layer.
4) At room temperature, the fourth water contact angle of the surface on which the inhibitor is deposited is measured.
5) The second increase of the water contact angle is the value obtained by subtracting the third water contact angle from the fourth water contact angle.

The second increase of the water contact angle can be derived by the following Equation 2.

Second increase of the Water Contact Angle = Fourth Water Contact Angle - Third Water Contact Angle [Equation 2]

The second increase of the water contact angle may exceed approximately 20°. The second increase of the water contact angle may exceed approximately 25°. The second increase of the water contact angle may exceed approximately 30°. The second increase of the water contact angle may exceed approximately 35°. The second increase of the water contact angle may exceed approximately 40°. The maximum value of the second increase of the water contact angle may be approximately 80°.

The Third Water Contact Angle may be approximately 10° to approximately 40°. The Third Water Contact Angle may be approximately 15° to approximately 35°. The Third Water Contact Angle may be approximately 10° to approximately 30°.

The fourth water contact angle may be approximately 50° to approximately 85°. The fourth water contact angle may be approximately 55° to approximately 80°. The fourth water contact angle may be approximately 60° to approximately 75°.

The second semiconductor substrate may be formed by a sputtering process. To form the second semiconductor substrate, a tungsten metal sputtering target may be used to form a tungsten metal layer on a silicon wafer.

The inhibitor may cause a third increase of the water contact angle. The third increase of the water contact angle may be measured using the following measurement method 3.

Measurement Method 3

1) The surface of the third semiconductor substrate comprising a silicon nitride film is surface-treated with a hydrogen fluoride solution. The hydrogen fluoride solution may contain 99.9 wt% deionized water and 0.1 wt% hydrogen fluoride. The third semiconductor substrate may be immersed in the hydrogen fluoride solution for approximately 30 seconds.
2) The inhibitor is deposited on the surface-treated silicon nitride film for 30 seconds at a temperature of approximately 150°C and a process pressure of 1 Torr.
3) At room temperature, the fifth water contact angle of the silicon nitride film surface-treated with hydrogen fluoride is measured. The fifth water contact angle is measured before the inhibitor is deposited on the surface-treated silicon nitride film.
4) At room temperature, the sixth water contact angle of the surface on which the inhibitor is deposited is measured.
5) The third increase of the water contact angle is the value obtained by subtracting the fifth water contact angle from the sixth water contact angle.

The third increase of the water contact angle can be derived by the following Equation 3.

[Equation 2]

Third increase of the water contact angle = sixth contact angle - fifth contact angle

The third increase of the water contact angle may be approximately -20° to approximately 20°. The third increase of the water contact angle may be approximately -15° to approximately 15°. The third increase of the water contact angle may be approximately -10° to approximately 10°.

The fifth contact angle may be approximately 20° to approximately 60°. The fifth contact angle may be approximately 25° to approximately 50°. The fifth contact angle may be approximately 30° to approximately 45°.

The sixth contact angle may be approximately 20° to approximately 60°. The sixth contact angle may be approximately 25° to approximately 50°. The sixth contact angle may be about 30° to about 45°.

The third semiconductor substrate may be formed by a chemical vapor deposition process.

The chemical vapor deposition process may be selected from an atmospheric pressure chemical vapor deposition (APCVD), a low pressure chemical vapor deposition (LPCVD), or a plasma enhanced chemical vapor deposition (PECVD).

To form the third semiconductor substrate, a silicon-based precursor and a nitrogen-based precursor may be

introduced onto a silicon wafer. Through the chemical vapor deposition process, the silicon nitride film may be formed by the precursors.

To form the third semiconductor substrate, when the atmospheric pressure chemical vapor deposition process is performed, the process temperature is approximately 900°C to approximately 1000°C, the silicon-based precursor may be silane, and the nitrogen-based precursor may be ammonia. To form the third semiconductor substrate, when the low-pressure chemical vapor deposition process is carried out, the process temperature is approximately 700°C to approximately 900°C, the silicon-based precursor may be dichlorosilane, and the nitrogen-based precursor may be ammonia.

To form the third semiconductor substrate, when the plasma-enhanced chemical vapor deposition process is carried out, the process temperature is approximately 250°C to approximately 350°C, the silicon-based precursor may be silane, and the nitrogen-based precursor may be ammonia.

The silicon oxide film may contain Si3N4 as a main component.

The inhibitor may cause a fourth increase of the water contact angle. The fourth increase of the water contact angle can be measured using the following measurement method 4.

Measurement Method 4

1) The surface of the fourth semiconductor substrate containing the silicon oxide film is surface-treated with a hydrogen fluoride solution. The hydrogen fluoride solution may contain 99.9 wt% deionized water and 0.1 wt% hydrogen fluoride. The fourth semiconductor substrate may be immersed in the hydrogen fluoride solution for approximately 30 seconds.
2) The inhibitor is deposited on the surface-treated silicon oxide film for 30 seconds at a temperature of approximately 150°C and a process pressure of 1 Torr.
3) At room temperature, the seventh number contact angle of the silicon oxide film surface-treated with the hydrogen fluoride is measured. The seventh number contact angle is measured before the inhibitor is deposited on the surface-treated silicon oxide film.
4) At room temperature, the eighth number contact angle of the surface on which the inhibitor is deposited is measured.
5) The fourth increase of the water contact angle is the value obtained by subtracting the seventh number contact angle from the eighth number contact angle.

The fourth increase of the water contact angle can be derived by the following Equation 4.

[Equation 4]

$$\text{Fourth increase of the water contact angle} = \text{eighth contact angle} - \text{seventh contact angle}$$

The fourth increase of the water contact angle may be approximately 0° to approximately 40°. The fourth increase of the water contact angle may be approximately 5° to approximately 40°. The fourth increase of the water contact angle may be approximately 10° to approximately 40°.

The seventh contact angle may be approximately 0° to approximately 30°. The seventh contact angle may be approximately 3° to approximately 25°. The seventh contact angle may be approximately 0° to approximately 15°.

The eighth contact angle may be approximately 10° to approximately 50°. The eighth contact angle may be approximately 10° to approximately 45°. The eighth contact angle may be approximately 15° to approximately 45°.

The fourth semiconductor substrate may be formed by a chemical vapor deposition process.

The chemical vapor deposition process may be selected from an atmospheric pressure chemical vapor deposition (APCVD), a low pressure chemical vapor deposition (LPCVD), or a plasma enhanced chemical vapor deposition (PECVD).

To form the fourth semiconductor substrate, a silicon-based precursor and an oxygen-based precursor may be introduced onto a silicon wafer. Through the chemical vapor deposition process, the silicon oxide film may be formed by the precursors.

When the atmospheric pressure chemical vapor deposition process is performed to form the fourth semiconductor substrate, the process temperature is approximately 200°C to approximately 500°C, the silicon-based precursor may be silane, and the oxygen-based precursor may be oxygen.

To form the fourth semiconductor substrate, when the low-pressure chemical vapor deposition process is performed, the process temperature is approximately 800°C to approximately 1000°C, the silicon-based precursor may be dichlorosilane, and the oxygen-based precursor may be oxygen.

To form the fourth semiconductor substrate, when the plasma-enhanced chemical vapor deposition process is performed, the process temperature is approximately 200°C to approximately 300°C, the silicon-based precursor may be dichlorosilane, and the oxygen-based precursor may be nitrous oxide ($N_2O$).

The silicon oxide film may contain $SiO_2$ as a main component.

The inhibitor may contain a fluorine-based compound as described above and may have the first increase of the water contact angle within the range described above.

Accordingly, the inhibitor is temporarily adsorbed onto the titanium nitride film, thereby effectively preventing the deposition of the thin film on the titanium nitride film.

In particular, since the semiconductor process composition such as the inhibitor above contains fluorine, the semiconductor process composition can effectively block the chemical reaction between the precursor for forming the thin film and the titanium nitride film.

In addition, the semiconductor process composition such as the inhibitor above is effectively adsorbed onto the tungsten layer and may have a second increase of the water contact angle exceeding about 20°.

Accordingly, the semiconductor process composition such as the inhibitor above is temporarily adsorbed onto the tungsten layer and can effectively prevent the thin film from being deposited on the tungsten layer.

In addition, the inhibitor may include a ketone-based compound containing fluorine. In addition, the inhibitor may include functional groups such as hydroxyl groups.

Accordingly, the ketone group and/or the hydroxyl group are effectively adsorbed onto the deposition exclusion region (NGA) and can expose the fluorine to the surface of the deposition prevention layer formed by the inhibitor.

Accordingly, the inhibitor can effectively protect the deposition exclusion region (NGA) from the precursor. Accordingly, a thin film can be formed with a high selectivity ratio in the deposition target region (GA).

In addition, the fluorine-based compound may have a molecular weight within the range described above and a boiling point within the range described above.

Accordingly, the inhibitor can be easily introduced into the semiconductor substrate (100) even at low temperatures. Accordingly, the inhibitor can form the deposition prevention layer thinly and uniformly in the deposition exclusion region (NGA).

In addition, the inhibitor is not adsorbed on the silicon oxide film or is weakly adsorbed. Accordingly, the inhibitor does not form the deposition prevention layer on the silicon oxide film. Accordingly, the inhibitor can selectively deposit the target film only on the silicon oxide film.

In addition, the method for manufacturing a semiconductor device according to the embodiment includes a first purge operation between the first adsorption operation and the second adsorption operation. That is, the method for manufacturing a semiconductor device according to the embodiment introduces the inhibitor into the deposition exclusion region (NGA) stepwise to form the reaction inhibition layer stepwise.

Accordingly, the method for manufacturing a semiconductor device according to the embodiment can effectively remove residues of the inhibitor from the deposition target area (GA) while forming the reaction inhibition layer thinly and uniformly in the deposition exclusion area (NGA).

In addition, the method for manufacturing a semiconductor device according to the embodiment can utilize the inhibitor to extend the process time of the first purge operation sufficiently. At this time, since the inhibitor is strongly bound to the deposition exclusion area (NGA), the first purge operation can have a sufficiently long process time.

Accordingly, the method for manufacturing a semiconductor device according to the embodiment can form the thin film in the deposition target area (GA) with an improved selectivity ratio.

In addition, the method for manufacturing a semiconductor device according to the embodiment can proceed with the first adsorption operation and the second adsorption operation at an appropriate process temperature, and proceed with the first purge operation at an appropriate process temperature.

Accordingly, the method for manufacturing a semiconductor device according to the embodiment can effectively remove residues of the inhibitor from the deposition target area (GA) while forming the reaction inhibition layer thinly and uniformly in the deposition exclusion area (NGA). Furthermore, the features, structures, effects, etc. described in the embodiments above are included in at least an embodiment of the present disclosure and are not necessarily limited to only an embodiment. Moreover, the features, structures, effects, etc. illustrated in each embodiment may be combined or modified and implemented in other embodiments by those skilled in the art to which the embodiments belong. Therefore, details regarding such combinations and modifications should be interpreted as being included within the scope of the present disclosure.

Although the description has focused on specific embodiment, these are merely illustrative and do not limit the scope of the present disclosure. Those skilled in the art to which the present disclosure belongs will understand that various modifications and applications to the embodiments not illustrated above are possible within the scope that does not deviate

from the essential characteristics of the embodiments. For example, each component specifically shown in the embodiments may be modified and implemented. Furthermore, differences related to such modifications and applications should be interpreted as being included within the scope of the embodiments of the present disclosure as defined in the appended claims. Furthermore, the embodiments may be combined to form addition al embodiments.

Preparation Example

Silicon Wafer #1: Silicon wafer with a titanium nitride film formed thereon.
Silicon Wafer #2: Silicon wafer with a tungsten layer formed thereon.
Silicon Wafer #3: Silicon wafer with a silicon nitride film formed thereon.
Silicon Wafer #4: Silicon wafer with a silicon oxide film formed thereon.
Hydrogen Fluoride Solution: A solution in which hydrogen fluoride (0.1 wt%) is dissolved in deionized water.
Inhibitor: Hexafluoroacetylacetone (Sigma-Aldrich product)
Precursor: 1,2-Bis(diisopropylamino)disilane (BDIPADS)

Preparation Example 1

The silicon wafer #1 was immersed in the hydrogen fluoride solution for about 30 seconds. Afterward, the silicon wafer #1 was placed in a chamber (CN1, Atomic Classic), and argon gas was introduced into the chamber for about 30 seconds to perform a purging process. Subsequently, the inhibitor was introduced into the chamber at a process temperature of approximately 150°C and a process pressure of approximately 1 Torr for about 30 seconds. Accordingly, silicon wafer #1 surface-treated with the inhibitor was manufactured.

In addition, the same process as above was performed on silicon wafer #2, silicon wafer #3, and silicon wafer #4.

Preparation Example 2

As shown in Table 1 below, the process pressure was adjusted to 0.5 Torr, and the remaining process was performed in the same manner as in Preparation Example 1.

Preparation Example 3

The silicon wafer #1 was immersed in the hydrogen fluoride solution for about 30 seconds. Subsequently, the silicon wafer #1 was placed in a chamber (CN1, Atomic Classic product), and argon gas was introduced into the chamber for about 30 seconds to perform a purging process. Subsequently, the inhibitor was introduced into the chamber at a process temperature of approximately 150°C and a process pressure of approximately 0.5 Torr for about 3 seconds to perform a first adsorption process. Subsequently, argon gas was introduced into the chamber for approximately 30 seconds to perform the first purging process. Subsequently, the inhibitor was introduced into the chamber for approximately 3 seconds at a process pressure of approximately 0.5 Torr and a process temperature of approximately 150°C to perform the second adsorption process. Subsequently, argon gas was introduced into the chamber for approximately 30 seconds to perform the second purging process. Subsequently, the inhibitor was introduced into the chamber for approximately 3 seconds at a process pressure of approximately 0.5 Torr and a process temperature of approximately 150°C to perform the third adsorption process. Subsequently, argon gas was introduced into the chamber for approximately 30 seconds to perform the third purging process.

In addition, the same process as above was performed on silicon wafer #2, silicon wafer #3, and silicon wafer #4.

Preparation Examples 4 to 9

As shown in Tables 1 and 2 below, in each adsorption process and each purging process, the process time and process temperature were controlled, and the remaining process was carried out in the same manner as Preparation Example 3.

Table 1

| Classification | First adsorption process time (seconds) | First adsorption process temperature (°C) | First purge process time (seconds) | Second adsorption process time (seconds) | second adsorption process temperature (°C) | second purge process time (seconds) |
|---|---|---|---|---|---|---|
| Preparation Examples 3 | 3 | 150 | 30 | 3 | 150 | 30 |
| Preparation Examples 4 | 3 | 250 | 30 | 3 | 250 | 30 |
| Preparation Examples 5 | 3 | 350 | 30 | 3 | 350 | 30 |
| Preparation Examples 6 | 3 | 450 | 30 | 3 | 450 | 30 |
| Preparation Examples 7 | 10 | 150 | 20 | 10 | 150 | 20 |
| Preparation Examples 8 | 5 | 150 | 20 | 5 | 150 | 20 |
| Preparation Examples 9 | 3 | 150 | 20 | 3 | 150 | 20 |

Table 2

| Classification | third adsorption process time (seconds) | third adsorption process temperature (°C) | third purge process time (seconds) |
|---|---|---|---|
| Preparation Examples 3 | 3 | 150 | 30 |
| Preparation Examples 4 | 3 | 250 | 30 |
| Preparation Examples 5 | 3 | 350 | 30 |
| Preparation Examples 6 | 3 | 450 | 30 |
| Preparation Examples 7 | 10 | 150 | 20 |
| Preparation Examples 8 | 5 | 150 | 20 |
| Preparation Examples 9 | 3 | 150 | 20 |

Example

The silicon wafers prepared in Preparation Example 7 were placed in a chamber. Subsequently, the precursor was introduced into the chamber for 2 seconds at a temperature of approximately 150°C and a pressure of approximately 0.35 Torr. Subsequently, argon gas was introduced into the chamber for approximately 30 seconds. Subsequently, ozone gas was introduced into the chamber for approximately 30 seconds. Subsequently, argon gas was introduced into the chamber for approximately 60 seconds to form an atomic layer. The atomic layer formation process was performed 60 times.

Comparative Example

Silicon wafers that were surface-treated with the hydrogen fluoride solution and not treated with the inhibitor were used. The remaining process was carried out in the same manner as in the example.

Evaluation Example

1. Measurement of Water Contact Angle

On the surface of the silicon wafers prepared in the Preparation Examples, three points were randomly selected, and at these points at room temperature, the water contact angle was measured by a surface energy meter (FEMTOFAB, SDL200TEZD). In addition, the water contact angle was derived as the average of the values measured at the points.

2. Thickness Measurement

The thickness of the thin films prepared in the Examples and Comparative Examples was measured at two points

using an ellipsometer (Nano View Co., MG-1000). The thickness of the thin films was derived as the average of the measured values.

The contact angles of silicon wafers surface-treated with a hydrogen fluoride solution were measured as shown in Table 3 below.

Table 3

| Classification | Silicon oxide film Contact angle (°) | Silicon Nitride Film Contact Angle (°) | Titanium nitride film Contact angle (°) | Tungsten layer Contact angle (°) |
|---|---|---|---|---|
| Inhibitor untreated | 5 | 41 | 32 | 19 |

As shown in Table 4 below, the contact angles of silicon wafers manufactured by the manufacturing examples were measured.

Table 4

| Classification | Silicon oxide film Contact angle (°) | Silicon Nitride Film Contact Angle (°) | Titanium nitride film Contact angle (°) | Tungsten layer Contact angle (°) |
|---|---|---|---|---|
| Preparation Examples 1 | 29 | 45 | 68 | 61 |
| Preparation Examples 2 | 19 | 38 | 65 | 65 |
| Preparation Examples 3 | 31 | 44 | 66 | 68 |
| Preparation Examples 4 | 12 | 28 | 48 | 38 |
| Preparation Examples 5 | 15 | 19 | 37 | 3 |
| Preparation Examples 6 | 20 | 19 | 37 | 14 |
| Preparation Examples 7 | 44 | 55 | 68 | 70 |
| Preparation Examples 8 | 38 | 51 | 66 | 67 |
| Preparation Examples 9 | 32 | 45 | 69 | 67 |

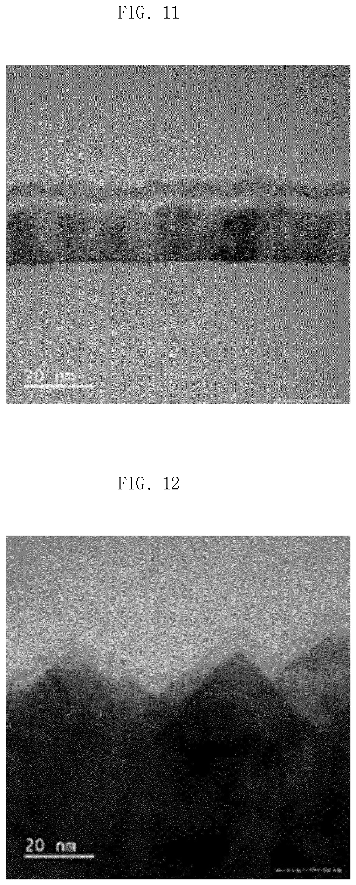

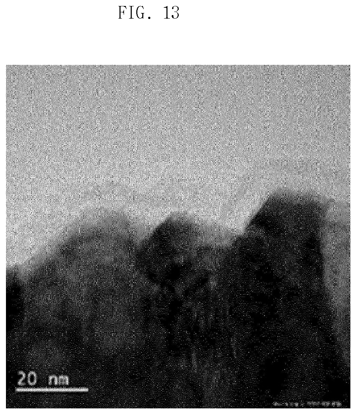

As shown in Table 5 and FIGS. 10 to 13 below, the thickness of the thin films deposited in the examples and comparative examples was measured.

Table 5

| Classification | Silicon Wafer #1 Deposition Thickness (nm) | Silicon Wafer #2 Deposition Thickness (nm) | Silicon Wafer #3 Deposition Thickness (Å) | Silicon Wafer #4 Deposition Thickness (Å) |
|---|---|---|---|---|
| Example | 0 | 0.5 | 41.3 | 49.7 |
| Comparative example | 3 | 3.4 | 49.1 | 52.2 |

As described in Tables 3 to 5 above, the method for manufacturing a semiconductor device according to the embodiment can form a desired film with an improved selectivity.

## Claims

**1.** A semiconductor process composition comprising: a compound containing fluorine,
wherein the semiconductor process composition exhibits a first increase of the water contact angle measured using measurement method 1 that exceeds 20°, wherein the measurement method 1 includes:

1) subjecting to a surface-treatment with hydrogen fluoride a surface of a semiconductor substrate containing a titanium nitride film,
2) depositing the semiconductor process composition on the surface-treated titanium nitride film for 30 seconds at a temperature of 150°C and a process pressure of 1 Torr,

3) measuring at room temperature, the first water contact angle of the titanium nitride film surface-treated with hydrogen fluoride,
4) measuring at room temperature, the second water contact angle of the surface on which the semiconductor process composition is deposited, and
5) determining the first increase of the water contact angle as the value obtained by subtracting the first water contact angle from the second water contact angle.

**2.** The semiconductor process composition according to claim 1, wherein a second increase of the water contact angle is measured using the following measurement method 2 exceeds 20°,
wherein measurement method 2 includes:

1) surface treating with hydrogen fluoride a surface of a semiconductor substrate containing a tungsten layer,
2) depositing the semiconductor process composition on the surface-treated tungsten layer for 30 seconds at a temperature of 150°C and a process pressure of 1 Torr,
3) measuring at room temperature, a third water contact angle of the tungsten layer surface-treated with hydrogen fluoride,
4) measuring at room temperature, a fourth water contact angle of the surface on which the semiconductor process composition is deposited,
5) and determining the second increase of the water contact angle as the value obtained by subtracting the third water contact angle from the fourth water contact angle.

**3.** The semiconductor process composition according to claim 1, wherein the fluorine containing compound includes ketone-based compounds.

**4.** The semiconductor process composition according to claim 1, wherein the fluorine containing compound is represented by the following chemical formula 1,

chemical formula 1

O
R1 R2

wherein in the chemical formula 1, R1 is an alkyl group substituted with fluorine and having 1 to 3 carbon atoms, and R2 is an alkenyl group substituted with fluorine and having 1 to 6 carbon atoms.

**5.** The semiconductor process composition according to claim 1, wherein the fluorine containing compound is represented by the following Chemical Formula 2,

Chemical Formula 2

O R5
R1 R3
R4

wherein in the chemical formula 2, R1 is an alkyl group substituted with fluorine and having 1 to 3 carbon atoms, R3 is an alkyl group substituted with fluorine and having 1 to 3 carbon atoms, R4 is selected from at least one group consisting of hydrogen, fluorine, or an alkyl group substituted with fluorine and having 1 to 3 carbon atoms, and R5 includes a hydroxyl group.

**6.** The semiconductor process composition according to claim 1, wherein the fluorine containing compound includes hexafluoroacetylacetone.

**7.** The semiconductor process composition according to claim 1, wherein the fluorine containing compound has a molecular weight of 100 g/mol to 500 g/mol.

**8.** The semiconductor process composition according to claim 1, wherein the semiconductor process composition has a boiling point of 60°C to 100°C at atmospheric pressure.

**9.** The semiconductor process composition according to claim 1, wherein an eighth water contact angle measured using the following measurement method 3 is 20° to 50°,
wherein the measurement method 3 includes:

1) surface-treating a surface of a semiconductor substrate containing a silicon oxide film with hydrogen fluoride,
2) depositing the semiconductor process composition on the surface-treated silicon oxide film for 30 seconds at a temperature of 150°C and a process pressure of 1 Torr, and
3) measuring the eighth water contact angle at room temperature on the surface of the silicon oxide film on which the semiconductor process composition is deposited.

**10.** A method for manufacturing a semiconductor device, the method comprising:

an operation of preparing a semiconductor substrate including a deposition target area and a deposition exclusion area;
a first adsorption operation of introducing an inhibitor containing fluorine, which is selectively adsorbed onto the deposition exclusion area, onto the semiconductor substrate;
a first purge operation of removing the inhibitor remaining in the deposition target area;
a second adsorption operation of introducing the inhibitor into the deposition exclusion area after the first purge operation; and
an operation of forming a thin film in the deposition target area.

**11.** The method for manufacturing a semiconductor device according to claim 10, further comprising: a second purge operation for removing an inhibitor remaining in the deposition target area after the second adsorption operation;

a third adsorption operation for introducing the inhibitor into the deposition exclusion area after the second purge operation; and
a third purge operation for removing an inhibitor remaining in the deposition target area after the third adsorption operation.

**12.** The method for manufacturing a semiconductor device according to claim 10, wherein the deposition target region comprises a silicon oxide film or a silicon nitride film and the deposition exclusion region comprises a titanium nitride film or a tungsten layer.

**13.** The method for manufacturing a semiconductor device according to claim 10, wherein in the first purge operation, an inert gas is introduced into the semiconductor substrate, and the process time in the first purge operation is 1.5 to 4.0 times longer than the process time in the first adsorption operation.

**14.** The method for manufacturing a semiconductor device according to claim 13, wherein in the first adsorption operation and the second adsorption operation, the adsorption process temperature is 50°C to 120°C higher than the boiling point of the inhibitor.

**15.** The method for manufacturing a semiconductor device according to claim 14, wherein in the first purging operation, the purging process temperature is 70°C to 200°C higher than the boiling point of the inhibitor.

**16.** A deposition inhibitor composition for semiconductor processes comprising a fluorine-based compound represented by the following Chemical Formula 1, which adsorbs onto a titanium nitride film or a tungsten layer,

Chemical Formula 1

O
R1
R2

wherein in the chemical formula 1, R1 is an alkyl group substituted with fluorine and having 1 to 3 carbon atoms, and R2 is an alkenyl group substituted with fluorine and having 1 to 6 carbon atoms.

**17.** The semiconductor process inhibitor deposition composition according to claim 16, comprising a fluorine-based compound represented by the following Chemical Formula 2,

Chemical Formula 2

O
R5
R1
R3
R4

wherein the chemical formula 2, R1 is an alkyl group substituted with fluorine and having 1 to 3 carbon atoms, R3 is an alkyl group substituted with fluorine and having 1 to 3 carbon atoms, R4 is selected from at least one group consisting of hydrogen, fluorine, or an alkyl group substituted with fluorine and having 1 to 3 carbon atoms, and R5 includes a hydroxyl group.

**18.** The semiconductor process inhibitor deposition composition according to claim 16, comprising a fluorine-based compound represented by the following Chemical Formula 3,

Chemical Formula 3

H
O
O
F3C
CF3 .

**19.** The semiconductor process inhibitor deposition composition according to claim 16, wherein the fluorine-based compound has a molecular weight of 100 g/mol to 500 g/mol.

**20.** The semiconductor process inhibitor deposition composition according to claim 16, wherein the fluorine-based compound has a boiling point of 60°C to 100°C at atmospheric pressure.

FIG. 1

NGA
GA
100
130
120
110

FIG. 2

inhibitor
NGA
GA
210
201
100
130
120
110

FIG. 3

inert gas
NGA
GA
210
100
130
120
110

FIG. 4

inhibitor
NGA
GA
220
202
100
130
120
110

FIG. 5

inert gas
NGA
GA
220
100
130
120
110

FIG. 6

inhibitor
NGA
GA
200
203
100
130
120
110

FIG. 7

inert gas
NGA
GA
200
100
130
120
110

FIG. 8

NGA
GA
300
200
100
130
120
110

FIG. 9

NGA
GA
300
100
130
120
110

FIG. 10

20 nm

FIG. 11

20 nm

FIG. 12

20 nm

FIG. 13

20 nm

## INTERNATIONAL SEARCH REPORT

International application No. **PCT/KR2024/016482**

**A. CLASSIFICATION OF SUBJECT MATTER**

**C09K 13/00**(2006.01)i; **C09D 5/00**(2006.01)i; **C23C 16/04**(2006.01)i; **C23C 16/44**(2006.01)i; **H01L 21/32**(2006.01)i; **H01L 21/285**(2006.01)i

According to International Patent Classification (IPC) or to both national classification and IPC

**B. FIELDS SEARCHED**

Minimum documentation searched (classification system followed by classification symbols)

C09K 13/00(2006.01); B05D 1/00(2006.01); C07C 47/17(2006.01); C23C 16/02(2006.01); C23C 16/04(2006.01); H01L 21/02(2006.01); H01L 21/311(2006.01); H01L 21/32(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus) & keywords: 반도체(semiconductor), 불소 함유 화합물(fluorine-containing compound), 증착 억제제(deposition inhibitor), 실리콘 산화막(silicon oxide film), 티타늄 질화막(titanium nitride film), 텅스텐막(tungsten film)

**C. DOCUMENTS CONSIDERED TO BE RELEVANT**

| Category* | Citation of document, with indication, where appropriate, of the relevant passages | Relevant to claim No. |
|---|---|---|
| X<br>Y | 조현희 등. 열 원자층 식각법을 이용한 박막 재료 식각 연구. Journal of powder materials. electronic publication: 31 January 2023, vol. 30, no. 1, pp. 53-64 (JO, Hyeonhui et al. Thermal Atomic Layer Etching of the Thin Films: A Review.)<br>See abstract; pages 53-64; and page 60, section 3.2.2. | 1-9,16-20<br>10-15 |
| Y | KR 10-2021-0139299 A (TOKYO ELECTRON LIMITED) 22 November 2021 (2021-11-22)<br>See paragraphs [0016]-[0092]; and figure 2. | 10-15 |
| X<br>Y | KR 10-2023-0103945 A (SAMSUNG ELECTRONICS CO., LTD. et al.) 07 July 2023 (2023-07-07)<br>See claims 1 and 14; paragraphs [0004], [0025], [0026], [0034], [0035], [0059]-[0066], [0076], [0080]-[0084], [0108], [0109], [0136], [0139], [0175], [0177] and [0201]-[0210]; figures 1-3; and table 5. | 1-9,16-20<br>10-15 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 February 2025** | **18 February 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No. **PCT/KR2024/016482**

**C. DOCUMENTS CONSIDERED TO BE RELEVANT**

| Category* | Citation of document, with indication, where appropriate, of the relevant passages | Relevant to claim No. |
|---|---|---|
| A | KR 10-2021-0109465 A (KOKUSAI ELECTRIC CORPORATION) 06 September 2021 (2021-09-06) See paragraphs [0002], [0116] and [0210]. | 1-20 |
| A | KR 10-2023-0038256 A (KOKUSAI ELECTRIC CORPORATION) 17 March 2023 (2023-03-17) See claims 1 and 19; paragraphs [0054], [0055] and [0059]-[0064]; and figures 5-8. | 1-20 |

Form PCT/ISA/210 (second sheet) (July 2022)

**INTERNATIONAL SEARCH REPORT**
**Information on patent family members**

International application No.
**PCT/KR2024/016482**

| Patent document cited in search report | Publication date (day/month/year) | Patent family member(s) | Publication date (day/month/year) |
|---|---|---|---|
| KR 10-2021-0139299 A | 22 November 2021 | JP 2020-147788 A | 17 September 2020 |
| | | JP 7109397 B2 | 29 July 2022 |
| | | KR 10-2735017 B1 | 28 November 2024 |
| | | US 11830741 B2 | 28 November 2023 |
| | | US 2022-0189778 A1 | 16 June 2022 |
| | | WO 2020-184212 A1 | 17 September 2020 |
| KR 10-2023-0103945 A | 07 July 2023 | US 2023-0215723 A1 | 06 July 2023 |
| KR 10-2021-0109465 A | 06 September 2021 | CN 113314393 A | 27 August 2021 |
| | | CN 113314393 B | 05 July 2024 |
| | | JP 2021-136349 A | 13 September 2021 |
| | | JP 7072012 B2 | 19 May 2022 |
| | | KR 10-2559830 B1 | 27 July 2023 |
| | | SG 10202101966 A | 29 September 2021 |
| | | TW 202136558 A | 01 October 2021 |
| | | TW I821626 B | 11 November 2023 |
| | | US 11923193 B2 | 05 March 2024 |
| | | US 2021-0272803 A1 | 02 September 2021 |
| KR 10-2023-0038256 A | 17 March 2023 | CN 115868007 A | 28 March 2023 |
| | | JP 7431343 B2 | 14 February 2024 |
| | | TW 202212604 A | 01 April 2022 |
| | | TW 202323563 A | 16 June 2023 |
| | | TW I795844 B | 11 March 2023 |
| | | US 2023-0183864 A1 | 15 June 2023 |
| | | WO 2022-054216 A1 | 17 March 2022 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020230144207